# FASCICULE DE BREVET EUROPEEN

(11) **EP 2 159 801 B1**
(45) Date de publication et mention de la délivrance du brevet: **05.09.2012**
(21) Numéro de dépôt: 09168610.5
(22) Date de dépôt: 25.08.2009
(51) Int. Cl.: G11C 13/04, G11B 11/08, H01L 27/24

(54) **Dispositif de mémorisation de données à adressage optique**
Datenspeichervorrichtung mit optischer Adressierung
Optically addressed data memory device

(30) Priorité: 29.08.2008 FR 0855807
(43) Date de publication de la demande: 03.03.2010
(73) Titulaire: Commissariat à l'Énergie Atomique et aux Énergies Alternatives, 75015 Paris (FR)
(72) Inventeur: Gidon, Serge, 38140 La Murette (FR); Hyot, Bérangère, 38320 Eybens (FR)
(74) Mandataire: Ilgart, Jean-Christophe

(56) Documents cités:
- EP-A- 1 968 117
- US-A- 5 179 533

## Description

### DOMAINE TECHNIQUE

L'invention concerne un dispositif de mémorisation de données à adressage optique avec écriture, lecture et effacement de données par effet photoélectrique. L'invention concerne également un procédé de réalisation d'un tel dispositif.

### ÉTAT DE LA TECHNIQUE ANTÉRIEURE

Les applications informatiques ou multimédia demandent des capacités mémoires de plus en plus importantes, que se soit pour l'échange de données ou pour le marché de substitution des disques durs. Il existe plusieurs types de dispositifs mémoires pour enregistrer des données, tels que par exemple les mémoires de masse (disques durs (SSD ou « Solid State Drive » en anglais) ou disques optiques) ou les mémoires statiques (mémoires Flash, PCRAM, FeRAM, ...) appelées également mémoires solides dans la mesure où aucun élément mécanique mobile n'est utilisé.

Le document « 4-Mb MOSFET Selected µTrench Phase-Change Memory Experimental Chip » de F. Bedeschi et al., IEEE J. Solid-State Circuits, vol. 40, n°7, juillet 2005, décrit une mémoire à base d'un matériau à changement de phase (appelée également mémoire PC ram) dont le fonctionnement est basé sur une modification de l'état de cristallinité d'un volume du matériau à changement de phase (chalcogénure), enchâssé entre deux électrodes. Le passage d'une phase à l'autre, c'est-à-dire de l'état cristallin à l'état amorphe ou inversement, du chalcogénure est obtenu par chauffage Joule, au moyen d'une impulsion de courant plus ou moins importante. L'état de la mémoire peut alors être détecté par lecture de la résistance du volume de matériau à changement de phase qui est différente selon que le matériau soit dans un état amorphe ou dans un état cristallin.

Toutefois, avec ce type de mémoire, les augmentations de la capacité de stockage sont liées uniquement à l'augmentation de la densité d'intégration surfacique des éléments de stockage qui est liée à la réduction de la taille des éléments de stockage. De plus, afin d'accéder efficacement aux données, le bus d'accès doit être conçu pour minimiser les couplages électromagnétiques lors de l'adressage afin d'accepter des fréquences de fonctionnement toujours plus élevées pour avoir un temps d'accès court, ce qui pourrait poser des problèmes lors des évolutions ultérieures de l'intégration dans de telles mémoires.

Il existe également des mémoires dites « à micro-pointes » comportant un support de stockage adressé au moyen d'un réseau de micro-pointes mobiles. Ces micro-pointes modifient localement des propriétés physico-chimiques (par exemple mécanique, thermique ou électrique) de la surface du support de stockage pour y écrire des informations. Ces informations peuvent ensuite être lues par détection des modifications des propriétés physico-chimiques réalisées sur la surface du support. Dans ce type de mémoire, les extrémités des micro-pointes définissent la limite de la densité surfacique des éléments de stockage. La densité surfacique obtenue (par exemple comprise entre 0,1 Tbits/cm² et 0,5 Tbits/cm²) prédispose ces mémoires à des applications de grande capacité dans un petit volume, par exemple destinées à des dispositifs nomades. Par ailleurs, leur technologie de fabrication ne nécessitant pas de moyens lithographiques avancés, leur coût de fabrication reste peu élevé.

Le document « The "Millipede" - More than one thousand tips for future AFM data storage » de P. Vettiger et al., IBM J. Res. Develop., vol. 44, n°3, mai 2000, pages 323 à 340, décrit une mémoire à micro-pointes mettant en oeuvre les techniques de la microscopie à force atomique (AFM) sur la surface d'une couche de stockage à base de matériaux polymères. Les informations stockées dans cette mémoire se présentent sous forme de trous réalisés dans la couche de stockage.

Toutefois, de part leur fonctionnement, les mémoires à micro-pointes nécessitent un contact électrique et mécanique des micro-pointes avec la surface du support de stockage. Or, un tel contact implique une usure des pointes et du support de stockage, ce qui représente une source de problèmes pour la fiabilité du dispositif dans le temps. De plus, la taille de l'extrémité de la micro-pointe peut limiter la densité d'intégration des éléments mémoires car la taille minimale de l'extrémité de la micro-pointe pointe est supérieure à la taille des emplacements de mémorisation des données.

Des solutions d'intégration 3D dans lesquelles des couches mémoires sont empilées sont également connues. Toutefois, ces solutions font appel à des structures de diodes ou de transistors pour isoler électriquement les couches mémoires entre elles. De telles structures introduisent des complications technologiques pouvant nuire à l'optimisation de la densité d'intégration dans le dispositif mémoire.

Le document US 5 179 533 décrit un dispositif de mémorisation de données, comportant un empilement de couches comprenant une couche mémoire apte à réaliser un stockage de données dans une pluralité de portions de la couche mémoire par une modification d'une propriété physico-chimique du matériau desdites portions de la couche mémoire sous l'effet d'un courant électrique traversant lesdites portions de la couche mémoire et par l'intermédiaire d'un faisceau lumineux traversant la couche mémoire.

Le document EP 1 968 117 est une demande de brevet européen telle que définie à l'article 54(3) CBE, décrivant décrit un dispositif de mémorisation de données, comportant :
- un empilement de couches comprenant une couche mémoire à base d'un matériau à changement de phase disposée entre deux couches diélectriques, la couche mémoire étant apte à réaliser un stockage de données dans une pluralité de portions de la couche mémoire par une modification d'une propriété physico-chimique du matériau desdites portions de la couche mémoire sous l'effet d'un courant électrique traversant lesdites portions de la couche mémoire;
- une pluralité de colonnes à base d'un matériau électriquement conducteur disposées dans l'empilement de couches et traversant chaque couche de cet empilement ;
chacune desdites portions de la couche mémoire entourant une des colonnes.

### EXPOSÉ DE L'INVENTION

Un but de la présente invention est de proposer un dispositif de mémorisation de données à couches mémoires empilées présentant une meilleure fiabilité que les dispositifs de l'art antérieur, et dont la structure n'implique pas la présence d'éléments d'isolation entre les couches mémoires pouvant nuire à l'optimisation de la densité d'intégration dans le dispositif.

Pour cela, la présente invention propose un dispositif de mémorisation de données, comportant :
- un empilement de couches comprenant au moins une couche mémoire apte à réaliser un stockage de données dans une pluralité de portions de la couche mémoire par une modification d'au moins une propriété physico-chimique du matériau desdites portions de la couche mémoire sous l'effet d'un courant électrique traversant lesdites portions de la couche mémoire,
- une pluralité de colonnes photoconductrices disposées dans l'empilement de couches et traversant chaque couche de cet empilement,
   chacune desdites portions de la couche mémoire entourant une des colonnes photoconductrices.

Ainsi, on propose un dispositif mémoire à média, ou support de stockage, comportant au moins un empilement de couches formé par au moins une couche mémoire, par exemple disposée entre deux couches isolantes. La mémorisation dans le support mémoire est donc commandée optiquement par l'intermédiaire des colonnes photoconductrices lorsqu'au moins l'une d'elles est éclairée.

On entend par « colonne photoconductrice » une colonne formée d'un ou plusieurs matériaux et apte à devenir électriquement conductrice sous l'effet d'un éclairage optique. Cela couvre donc tous les effets avec création de paires électrons-trous qui amènent à la diffusion de porteurs majoritaires ou la compensation associées des porteurs minoritaires, à partir d'un éclairage lumineux de ces colonnes, dans le ou les matériaux de ces colonnes.

Du fait que les colonnes soient photoconductrices, un tel dispositif ne fait pas appel à un réseau de micro-pointes mobiles mais à un réseau de sources lumineuses pour son adressage, évitant ainsi les contraintes liées à ces micro-pointes.

De plus, la structure en empilement de couches permet de profiter au mieux d'une intégration tridimensionnelle des circuits de stockage, en réalisant un empilement des points mémoires, autorisant une augmentation aisée de la capacité de stockage. Il est donc possible d'obtenir avec un tel dispositif de très grandes capacités de stockage à faible coût, dans un volume réduit, sans étendre la surface de chaque couche mémoire.

De plus, lorsque l'empilement de couches comporte plusieurs couches mémoires, ce dispositif a pour avantage de pouvoir continuer de fonctionner même si une ou plusieurs des couches mémoires sont défaillantes, grâce aux autres couches mémoires de l'empilement.

Un tel dispositif permet également de réduire les courants transitoires associés aux capacités parasites entre les couches mémoires apparaissant généralement dans les dispositifs mémoires de l'art antérieur comportant un empilement de couches mémoires.

Enfin, étant donné que seule la colonne éclairée devient électriquement conductrice, un tel dispositif ne nécessite pas de structure d'isolation électrique entre les couches mémoires car les colonnes non éclairées reste électriquement isolante, aucune opération d'écriture, effacement ou lecture de données ne pouvant avoir lieu à un autre point mémoire que celui ou ceux choisis par l'utilisateur.

Lesdites portions de la couche mémoire peuvent être de forme annulaire.

Les colonnes photoconductrices peuvent être à base d'au moins un matériau photoconducteur. Ce matériau photoconducteur peut être du silicium non dopé et/ou de l'oxyde de zinc et/ou de l'antimoniure d'indium et/ou un alliage de tellure antimoine germanium (GeₓSb_{y}Te_{z}) et/ou un matériau photoconducteur organique.

Dans une variante, les colonnes photoconductrices peuvent comporter au moins deux couches de semi-conducteur de conductivités complémentaires, c'est-à-dire l'une de type P et l'autre de type N. Les colonnes photoconductrices forment ainsi des photodiodes PN ou PIN. Les colonnes photoconductrices peuvent également comporter une couche de semi-conducteur dopé et une couche métallique, formant ainsi des photodiodes Schottky.

Le dispositif peut comporter en outre une pluralité de sources lumineuses aptes à éclairer ladite pluralité de colonnes photoconductrices.

Ladite couche mémoire peut être à base d'au moins un matériau à changement de phase. Ainsi, l'écriture, l'effacement et la lecture des données sont réalisés par l'intermédiaire de l'état de cristallinité des points mémoires de la couche mémoire, ces points mémoires pouvant être des portions annulaires de la couche mémoire disposées autour des colonnes photoconductrices.

L'empilement de couches peut être formé par une alternance de couches isolantes et de couches mémoires.

Le dispositif de mémorisation de données peut comporter en outre une pluralité de tranchées réalisées dans l'empilement de couches et traversant toutes les couches de l'empilement, formant plusieurs portions, isolées électriquement les unes des autres, de l'empilement de couches et des colonnes photoconductrices.

Le dispositif peut comporter en outre au moins une couche électriquement conductrice disposée contre, ou en contact direct avec, l'empilement de couches et contre, ou en contact direct avec, le sommet ou la base des colonnes photoconductrices. Il est possible qu'à la place de cette couche électriquement conductrice, le dispositif puisse comporter d'autres moyens pour former une électrode de source ou de collection de charges participant à la circulation d'un courant électrique à travers les portions de mémorisation de la couche mémoire, par exemple des plots conducteurs formés contre la base de chacune des colonnes et tous reliés à un même potentiel électrique, ou encore un micropointe optique conductrice.

Le dispositif peut comporter en outre des moyens d'application de tension aux bornes de la couche mémoire, et/ou des moyens de sélection d'une ou plusieurs colonnes photoconductrices et/ou des moyens de sélection d'une ou plusieurs couches mémoires, et/ou des moyens de mesure de courant circulant dans une ou plusieurs couches mémoires. Ainsi, les différents moyens de sélection peuvent former une électronique de commande apte à sélectionner la ou les portions de la couche mémoire au niveau desquelles une opération (lecture, écriture ou effacement) est destinée à être réalisée. Les moyens de mesure de courant peuvent former des moyens de lecture des informations stockées dans les couches mémoires.

La pluralité de sources lumineuses peut comporter un réseau de sources optiques de type VCSEL.

Le dispositif peut comporter en outre au moins une couche optiquement réfléchissante, par exemple telle que l'empilement de couches soit disposé entre la couche optiquement réfléchissante et la pluralité de sources lumineuses, et/ou au moins une couche de protection formée sur l'empilement de couches. Le dispositif peut comporter en outre au moins une couche optiquement réfléchissante et/ou au moins une couche de protection formées contre, ou en contact direct avec, l'empilement de couches.

Au moins l'empilement de couches et les colonnes photoconductrices peuvent former un support de stockage mobile par rapport à la pluralité de sources lumineuses. De plus, le dispositif peut comporter des moyens de déplacement relatif du support de stockage par rapport à la pluralité de sources lumineuses.

La pluralité de sources lumineuses peuvent être disposées dans un système de type MOEMS (microsystème opto-électro-mécanique) apte à translater les sources lumineuses par rapport au support de stockage, et/ou les moyens de déplacement relatif du support de stockage par rapport à la pluralité de sources lumineuses comportent au moins un moteur de type MEMS (microsystème électromécanique).

L'invention concerne également un procédé de réalisation d'un dispositif de mémorisation de données, comportant au moins les étapes de :
- réalisation d'un empilement de couches comportant au moins une couche mémoire apte à réaliser un stockage de données dans une pluralité de portions de la couche mémoire par une modification d'au moins une propriété physico-chimique du matériau desdites portions de la couche mémoire sous l'effet d'un courant électrique traversant lesdites portions de la couche mémoire,
- gravure d'une pluralité de trous dans l'empilement de couches, les trous traversant chaque couche de l'empilement,
- réalisation de colonnes photoconductrices dans les trous, chacune desdites portions de la couche mémoire entourant une des colonnes photoconductrices.

Le procédé peut comporter en outre une étape de réalisation d'une pluralité de sources lumineuses aptes à éclairer la pluralité de colonnes photoconductrices.

La réalisation de l'empilement de couches peut être obtenue par des étapes de dépôts alternés de couches isolantes et de couches mémoires.

Le procédé peut comporter en outre, après la réalisation de l'empilement de couches, une étape de réalisation d'une pluralité de tranchées dans l'empilement, traversant toutes les couches de l'empilement et formant plusieurs portions isolées les unes des autres de l'empilement de couches.

L'étape de réalisation des colonnes photoconductrices peut comporter en outre la réalisation de photodiodes aux interfaces avec la couche mémoire.

L'étape de réalisation des colonnes photoconductrices comporte une étape de remplissage des trous par au moins un matériau photoconducteur, ou une première étape de dépôt conforme aux parois des trous d'une première couche à base d'un semi-conducteur dopé d'un premier type de conductivité et une seconde étape de dépôt d'un semi-conducteur dopé d'un second type de conductivité complémentaire au premier type de conductivité ou d'un matériau électriquement conducteur sur la première couche.

La réalisation des colonnes peut être obtenue par la mise en oeuvre d'au moins une première étape de dépôt conforme d'une couche de matériau photoconducteur dans les trous, et d'une seconde étape de dépôt d'un matériau conducteur dans les trous, contre la couche de matériau photoconducteur.

Le procédé peut comporter en outre, après l'étape de réalisation des colonnes, une étape de dépôt d'une couche électriquement conductrice et/ou d'une couche de protection mécanique sur l'empilement de couches et sur les colonnes photoconductrices.

Le procédé peut comporter en outre, avant l'étape de réalisation de l'empilement de couches, une étape de dépôt d'une couche électriquement conductrice et/ou d'au moins une couche optiquement réflectrice contre un substrat, l'empilement de couches étant réalisé sur la couche électriquement conductrice et/ou sur la couche optiquement réflectrice.

### BRÈVE DESCRIPTION DES DESSINS

La présente invention sera mieux comprise à la lecture de la description d'exemples de réalisation donnés à titre purement indicatif et nullement limitatif en faisant référence aux dessins annexés sur lesquels :
- les figures 1 et 2 représentent des vues en coupe d'une partie d'un dispositif de mémorisation de données, objet de la présente invention, respectivement selon un premier et un second mode de réalisation,
- les figures 3A à 3E représentent les étapes d'un procédé de réalisation, également objet de la présente invention, d'un dispositif de mémorisation de données, objet de la présente invention, selon le premier mode de réalisation,
- la figure 4 représente une vue schématique globale d'un dispositif de mémorisation de données, objet de la présente invention.

Des parties identiques, similaires ou équivalentes des différentes figures décrites ci-après portent les mêmes références numériques de façon à faciliter le passage d'une figure à l'autre.

Les différentes parties représentées sur les figures ne le sont pas nécessairement selon une échelle uniforme, pour rendre les figures plus lisibles.

Les différentes possibilités (variantes et modes de réalisation) doivent être comprises comme n'étant pas exclusives les unes des autres et peuvent se combiner entre elles.

### EXPOSÉ DÉTAILLÉ DE MODES DE RÉALISATION PARTICULIERS

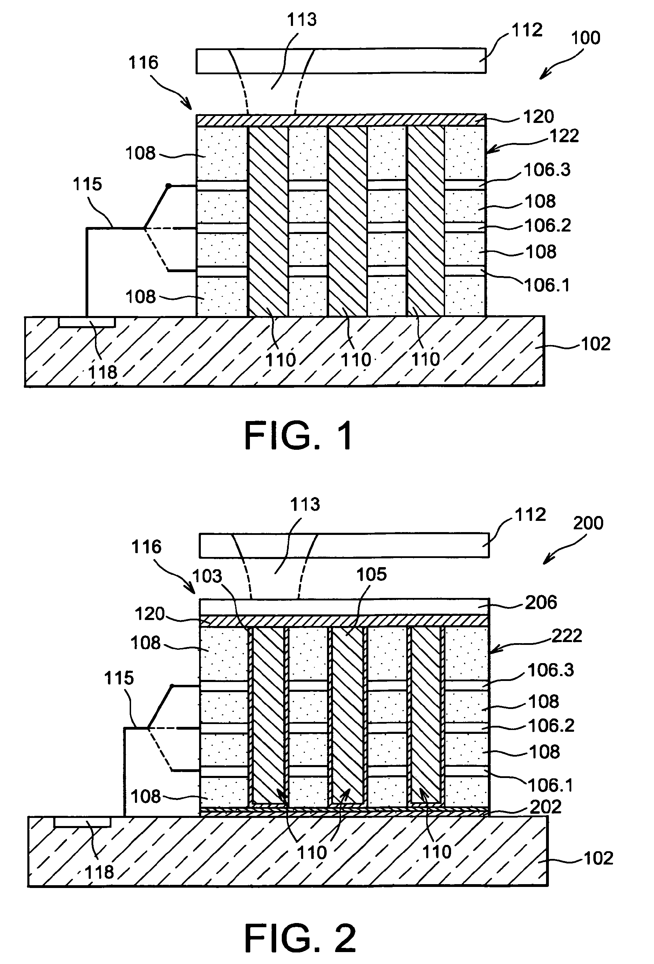

On se réfère tout d'abord à la figure 1 qui représente une vue en coupe d'une partie d'un dispositif de mémorisation de données 100 selon un premier mode de réalisation.

Le dispositif 100 comporte un substrat 102 par exemple à base de semi-conducteur tel que du silicium, et/ou de verre et/ou de plastique tel que du PMMA (polyméthacrylate de méthyle).

Le dispositif 100 comporte également plusieurs couches mémoires 106 dans lesquelles les données sont destinées à être mémorisées. Dans ce premier mode de réalisation, ces couches mémoires 106 sont à base d'un matériau à changement de phase, c'est-à-dire un matériau dont les propriétés de conduction électrique sont modifiables, et empilées sur le substrat 102. Les couches mémoires 106 peuvent par exemple être à base d'au moins un matériau de la famille des chalcogénures, par exemple du GeSe, et avantageusement des chalcogénures ternaires tels que du GeₓSb_{y}Te_{z} (par exemple du Ge₂Sb₂Te₅) et/ou de l'AgₓIn_{y}Sb_{z}Teₜ.

Sur la figure 1, seules trois couches 106.1 à 106.3 sont représentées. Toutefois, le dispositif 100 peut comporter un nombre différent de couches mémoires 106, par exemple huit couches mémoires, ou encore entre deux et dix couches mémoires, voir plus.

Ces couches 106 sont appelées « couches mémoires » et sont isolées à la fois mécaniquement, électriquement et thermiquement les unes des autres et du substrat 102 par des couches isolantes 108, ou couches diélectriques, à base d'un matériau tel que de la silice et/ou du nitrure de silicium et/ou de sulfure de zinc et/ou d'oxyde de silicium, et d'une épaisseur comprise entre environ 10 nm et 100 nm. Compte tenu de la faible conductivité thermique du matériau des couches isolantes 108 (par exemple égale à environ 0,6 W.m⁻¹.K⁻¹ pour un composé de ZnS et de SiO₂), celles-ci forment donc un bon isolant thermique entre les couches mémoires 106 afin que de la chaleur générée dans l'une de ces couches mémoires 106 ne se propage pas dans les autres couches mémoires 106.

Lors de la réalisation du dispositif 100, le matériau des couches mémoires 106 peut être en phase cristalline. Les couches mémoires 106 peuvent par exemple avoir une épaisseur comprise entre environ 1 nm et 30 nm, et avantageusement comprise entre environ 2 nm et 10 nm, et en particulier comprise entre environ 3 nm et 5 nm. Notamment, lorsque le matériau des couches mémoires 106 est de la famille des chalcogénures, le choix de l'épaisseur des couches mémoires 106 est réalisé en faisant un compromis entre une épaisseur réduite permettant d'accroître le confinement des lignes de courant dans ces couches, et une épaisseur suffisante pour que le matériau puisse changer d'état.

Dans ce premier mode de réalisation, chaque couche mémoire 106 est disposée entre deux couches isolantes 108. De manière générale, le dispositif 100 peut comporter au moins une couche mémoire disposée entre deux couches isolantes. Lorsque le dispositif 100 comporte plusieurs couches mémoires, chaque couche mémoire est disposée entre deux couches isolantes.

Le dispositif 100 comporte également plusieurs colonnes photoconductrices 110. Dans ce premier mode de réalisation, les colonnes photoconductrices 110 sont à base d'un matériau photoconducteur tel que du silicium non dopé et/ou de l'oxyde de zinc et/ou un matériau photoconducteur organique (OPC). Ces colonnes 110 traversent, par exemple perpendiculairement, les couches mémoires 106 et les couches isolantes 108. Sur la figure 1, seules trois colonnes photoconductrices 110 sont représentées. Ces colonnes 110 peuvent par exemple avoir une forme sensiblement cylindrique et être de dimensions sensiblement similaires les unes par rapport aux autres. Sur l'exemple de la figure 1, les colonnes 110 sont régulièrement espacées les unes des autres, par exemple d'une distance au moins égale à environ 200 nm, cette distance étant choisie pour être compatible avec la résolution de moyens de sélection optique destinés à éclairer les colonnes 110. Les colonnes 110 ont par exemple une section circulaire de diamètre égal à environ 100 nm ou plus généralement égale à environ la valeur de l'espacement entre ces colonnes. Toutefois, il est possible que les sections des colonnes soient de formes différentes, par exemple rectangulaires, triangulaires ou d'une toute autre forme géométrique et/ou de dimensions différentes.

Les couches mémoires 106 et les couches isolantes 108 peuvent être structurées en plusieurs « caissons », ou portions, disposés sur le substrat 102 et isolés les uns des autres par du vide et/ou un matériau isolant. Sur l'exemple de la figure 1, un seul caisson 116 comportant les couches mémoires 106.1 à 106.3 et les couches isolantes 108 est représenté. Chaque caisson 116 peut par exemple comporter entre environ 1000 et 100000000 colonnes photoconductrices.

Chaque portion, par exemple de forme annulaire, des couches mémoires 106 entourant une colonne photoconductrice 110 forme un élément de mémorisation, ou point mémoire, du dispositif 100, dans lequel sont écrites, lues et effacées des informations.

Le dispositif 100 de la figure 1 comporte également une couche électriquement conductrice 120, formant une électrode, de source ou de collection de charges, disposée contre l'empilement des couches mémoires 106 et des couches isolantes 108, et contre les sommets des colonnes 110. Cette couche électriquement conductrice 120 est par exemple à base d'ITO (oxyde d'étain-indium) et/ou d'un métal (par exemple de l'or et/ou du titane et/ou du platine) et/ou du nitrure de titane et/ou encore de composés métalliques conducteurs tels que du siliciure (par exemple du PtSi) ou du carbone (de proportion sp3/sp2 telle que ce carbone soit conducteur). Cette couche 120 a une épaisseur comprise entre environ 1 nm et 10 nm, de telle sorte que sa conductivité permette le passage d'un courant entre cette couche électrode 120 et l'une des colonnes 110 au niveau de laquelle une opération de mémorisation de données est destinée à être réalisée. De plus, cette couche électriquement conductrice 120 est optiquement transparente. Cette transparence peut être obtenue en réalisant la couche électriquement conductrice 120 telle que son épaisseur soit comprise entre environ 1 nm et 10 nm, ou de préférence comprise entre environ 3 nm et 10 nm. La résistance électrique présentée par la couche électriquement conductrice 120 est inférieure ou égale à environ 100 kΩ. La conductivité de la couche 120, lorsque celle-ci est à base de carbone, est comprise entre environ 0,1 (Ω.cm)⁻¹ et 1 (Ω.cm)⁻¹.

Dans une variante de ce premier mode de réalisation, la couche conductrice 120 pourrait être disposée entre le substrat 102 et la première couche isolante 108, c'est-à-dire sous et contre l'empilement de couches 106, 108, et contre la base des colonnes 110.

Ainsi, l'empilement des couches mémoires 106, des couches isolantes 108, du substrat 102 et de la couche électriquement conductrice 120, et les colonnes photoconductrices 110, forment un support de stockage 122 du dispositif 100.

Le dispositif 100 comporte également des moyens de sélection 115 de couches mémoires 106, qui peuvent être associés à des moyens d'application de tension aux bornes des couches mémoires 106, tels qu'un circuit d'adressage, fixant par exemple le potentiel de l'une des couches mémoire 106 dans laquelle une information est destinée à être lue et/ou écrite. Ce potentiel peut par exemple être faible lorsqu'une opération de lecture est réalisée, élevée lors d'une opération d'écriture, et encore plus élevée pour une opération d'effacement. Ce potentiel appliqué est par exemple compris entre environ 0,5 V et 8 V. Dans cette gamme de valeurs, l'opération de lecture pourra être réalisée avec une tension comprise entre environ 0,5 V et 1 V, l'opération d'écriture avec une tension comprise entre environ 2 V et 4 V, et l'opération d'effacement avec une tension comprise entre environ 5 V et 8 V.

Le dispositif 100 comporte également un réseau de sources optiques 112, réalisé par exemple en technologie VCSEL (Laser à émission par la surface, ou « Vertical Cavity Source Emission Laser » en anglais). Ce réseau de sources optiques 112 permet de réaliser des émissions lumineuses très localisées en champ proche, mais également en champ lointain par l'entremise d'un réseau de microlentilles, permettant ainsi d'éclairer individuellement la ou les colonnes 110 dans lesquelles sont destinées à être réalisées des opérations de mémorisation de données (lecture, écriture ou effacement de donnée(s)), et rendre ainsi ces colonnes 110 électriquement conductrices lorsqu'elles sont éclairées.

Dans une variante, le réseau de sources optiques 112 pourrait être disposé sous le substrat 102, lorsque celui-ci est transparent aux longueurs d'ondes émises par ce réseau de sources optiques 112, les faisceaux lumineux traversant le substrat 102 avant d'atteindre les colonnes 110. Il pourrait également être intégré au substrat 102 afin qu'une émission lumineuse soit réalisée depuis la base des colonnes 110.

Le dispositif 100 comporte également des moyens 118 de mesure de courant, disposés au niveau du substrat 102. Sur l'exemple de la figure 1, les moyens 118 de mesure de courant sont reliés aux moyens de sélection 115 de couches mémoires. Les moyens de mesure de courant 118 peuvent comporter des moyens logiques de sélection d'adresse tels qu'un multiplexeur, tenant compte de la structure en caissons des couches mémoires 106 et des couches isolantes 108. Les moyens 118 de mesure de courant peuvent comporter au moins un amplificateur intégré et un convertisseur courant/tension, un comparateur à seuil, et un convertisseur charge/tension permettant de discriminer un niveau logique relatif au courant mesuré.

Une opération d'écriture d'un bit dans un élément de mémorisation du dispositif 100 de la figure 1 va maintenant être décrite.

La colonne 110, dans laquelle le bit d'information est destiné à être stocké, est sélectionnée en éclairant celle-ci par le réseau de sources lumineuses 112. Sur l'exemple de la figure 1, un faisceau lumineux 113 est représenté, éclairant l'une des colonnes 110. L'une des couches mémoires 106.1 à 106.3 dans laquelle on souhaite écrire un bit est ensuite sélectionnée par l'intermédiaire des moyens de sélection 115. Lorsque l'on polarise, par rapport à la couche électriquement conductrice 120, la couche mémoire 106 souhaitée (le potentiel appliqué aux autres couches mémoires étant par exemple similaire au potentiel de la couche électriquement conductrice 120, par exemple nul), et qu'une impulsion lumineuse est émise dans la colonne 110, la rendant ainsi électriquement conductrice pendant la durée de l'impulsion lumineuse, un courant circule depuis ladite couche mémoire 106 vers la couches électriquement conductrice 120 à travers la colonne 110. Dans une variante, et en fonction des différents potentiels appliqués, le courant pourrait également circulé depuis la couche électriquement conductrice 120 vers la couche mémoire 106 sélectionnée. La couche mémoire 106 sert donc également d'électrode lors d'une opération de lecture ou d'écriture dans un élément de mémorisation du dispositif. De plus, en disposant la couche électriquement conductrice 120 au-dessus de l'empilement des couches mémoires 106 et des couches diélectriques 108, cette couche 120 se trouve donc au plus proche de la zone la plus éclairée de la colonne 110, permettant ainsi d'assurer une meilleure conduction au passage du courant.

Ce courant conduit à un échauffement par effet Joule qui est concentré dans le voisinage de la colonne 110, au niveau de la couche mémoire 106 car c'est à cet endroit que la densité de courant est la plus forte. Sur la couronne de cet interface, si le courant est suffisant, le matériau à changement de phase de la couche mémoire est alors porté à une température supérieure à sa température de fusion (par exemple 650°C pour une couche mémoire à base de GeSbTe) pour que, lors d'un refroidissement brutal, tel qu'un arrêt du passage du courant du à l'arrêt de l'éclairage de la colonne 110 ou la suppression de la tension, le matériau à changement de phase, initialement à l'état cristallin, soit mis localement dans un état amorphe, peu conducteur. Un anneau, ou portion annulaire, de matériau amorphe est ainsi formé autour de la colonne 110 et constitue la forme physique du bit d'information écrit. Le matériau à l'état amorphe étant moins conducteur, celui-ci va dorénavant limiter le passage de courant entre la couche conductrice 120 et la couche mémoire 106 comportant la portion annulaire de matériau à l'état amorphe.

Le matériau photoconducteur confère aux colonnes 110 un comportement de transistor commandé optiquement. Le canal de ce transistor, qui serait formé par la colonne 110 éclairée, se met à conduire sous le processus de création de paires électrons-trous, assisté par la présence d'une différence de potentiel entre la couche électriquement conductrice 120 et la couche mémoire sélectionnée au point qu'un courant passe dans ces éléments.

La puissance thermique permettant le changement d'état du matériau de la couche mémoire sélectionnée, lors de la phase d'écriture, est liée à la puissance électrique (effet Joule) développée par les moyens de sélection de couche mémoire. Cette puissance est plus importante que celle injectée optiquement dans la colonne 110 pour commander la conduction de cette colonne 110. La puissance optique nécessaire pour le fonctionnement de ce dispositif est donc bien inférieure à celle utilisée par des disques optiques réinscriptibles dans lesquels les moyens d'éclairage optiques servent à l'écriture de données.

L'information peut ensuite être relue par les moyens 118 de mesure du courant circulant entre la couche conductrice 120 et la couche mémoire 106 sélectionnée. Pour cela, on polarise la couche mémoire 106 concernée par rapport à la couche conductrice 120 à une tension suffisamment faible pour ne pas risquer de réchauffer le matériau au point de le faire recristallisé. Il est alors possible de déduire du courant mesuré (qui est proportionnel à la résistance présentée par la portion annulaire dont on souhaite connaitre l'état) si une portion annulaire de matériau amorphe est présente ou non autour de la colonne 110, au niveau de la couche mémoire sélectionnée.

L'état de conduction de la couche mémoire dépend de la taille de la zone amorphe annulaire. Ainsi, il est possible de coder les informations sous forme binaire ou sous forme de bits constitués de plusieurs niveaux (bits discrétisés) dans une seule couche mémoire et autour d'une seule colonne 110, la taille possible de la zone amorphe dépendant de la puissance de l'effet joule lors de l'écriture (paramètre actif) et de la conductivité thermique du matériau des colonnes. En faisant varier la taille de la zone amorphe annulaire, en jouant sur le niveau de tension entre l'électrode d'injection et la couche mémoire, on peut alors coder les informations sous forme « multi-niveaux » par cellules, augmentant ainsi d'autant la capacité de la mémoire. Chaque point mémoire peut dans ce cas stocker plusieurs bits d'informations, le nombre de ces bits étant fonction du nombre d'états distincts réalisables au niveau d'une seule portion annulaire du matériau à changement de phase.

L'effacement d'une information au croisement d'une colonne 110 et d'une des couches mémoires 106.1 à 106.3 se fait avec un courant plus important que celui utilisé pour la lecture et l'écriture de l'information, et pendant un temps suffisant (par exemple compris entre environ 50 ns et 500 ns) pour permettre le chauffage à la température de cristallisation et le retour du volume de la portion annulaire de matériau amorphe à l'état cristallin, en le portant à une température dite de « cristallisation », par exemple supérieure à environ 170°C pour le GeSbTe, par exemple égale à environ 400°C.

On peut optimiser le temps d'accès en lecture et en écriture du dispositif de mémorisation 100 en groupant les informations en mots de, par exemple, 8, 16 ou 32 bits, chaque mot étant écrit dans toutes ou plusieurs des couches mémoires 106, au niveau d'une seule colonne 110. Le nombre de niveaux de mémorisation des colonnes, c'est-à-dire le nombre de couches mémoires 106 que comporte le dispositif de mémorisation 100 peut donc être adapté en fonction de la taille souhaitée des mots d'informations écrits ou lus.

La forme temporelle de l'impulsion lumineuse peut également être optimisée par l'électronique de contrôle du réseau de sources lumineuses 112 selon l'opération réalisée, avec par exemple un front d'extinction plus raide pour une opération d'écriture réalisant une trempe du matériau à changement de phase (avec par exemple un front d'extinction inférieur ou égal à environ 50 ns) que pour une opération de lecture ou une opération réalisant un recristallisation du matériau à changement de phase (avec par exemple un front d'extinction égal ou supérieur à environ 100 ns).

Un dispositif de mémorisation de données 200 selon un second mode de réalisation va maintenant être décrit en liaison avec la figure 2.

Le dispositif 200 comporte la couche électriquement conductrice 120 qui peut être disposée au-dessus ou en dessous de l'empilement de couches mémoires 106.1 à 106.3 et de couches isolantes 108. Par rapport au premier mode de réalisation, le dispositif 200 comporte en outre une structure de photodiodes disposées aux interfaces avec les couches mémoires 106.1 à 106.3 et formées par les colonnes photoconductrices 110 elles-mêmes. Dans ce second mode de réalisation, chaque colonne photoconductrice 110 comporte des parois 103, en contact avec les couches 106 et 108 de l'empilement, formées par une première couche à base d'un semi-conducteur d'un premier type de conductivité, et une partie centrale 105 à base d'un semi-conducteur de conductivité complémentaire à celle de la première couche 103. Les photodiodes formées par les colonnes 110 sont donc ici du type à deux semiconducteurs complémentaires en dopages. Dans une variante, lorsque la partie centrale 105 des colonnes est à base d'un matériau métallique, les photodiodes formées par les colonnes photoconductrices 110 sont alors de type Schottky. Ainsi, lorsque la lumière traverse la colonne 110 choisie, la photodiode formée à l'interface de cette colonne et de la couche mémoire 106 correctement polarisée photo-génère des porteurs de charges qui traversent la couche mémoire polarisée, réalisant ainsi l'opération de lecture, d'écriture ou d'effacement de données au niveau de la portion annulaire de la couche mémoire sélectionnée se trouvant autour de la colonne 110 éclairée.

De plus, par rapport au dispositif 100 selon le premier mode de réalisation, le dispositif 200 comporte un empilement de couches 202 formant une structure « miroir », par exemple de type λ/4. Ainsi, la lumière issue du réseau de sources lumineuses 112 est reflétée au moins en partie dans les colonnes 110, renforçant ainsi le champ lumineux dans les colonnes 110. De manière générale, cette réflexion lumineuse peut être réalisée par au moins une couche optiquement réflectrice disposée en regard des colonnes 110 et de la source lumineuse éclairant les colonnes.

Enfin, le dispositif 200 comporte également une couche de protection 206 formée au dessus de l'empilement de couches mémoires 106 et de couches isolantes 108, et du sommet des colonnes 110. Cette couche de protection est par exemple à base de carbone diamant et/ou de plastique.

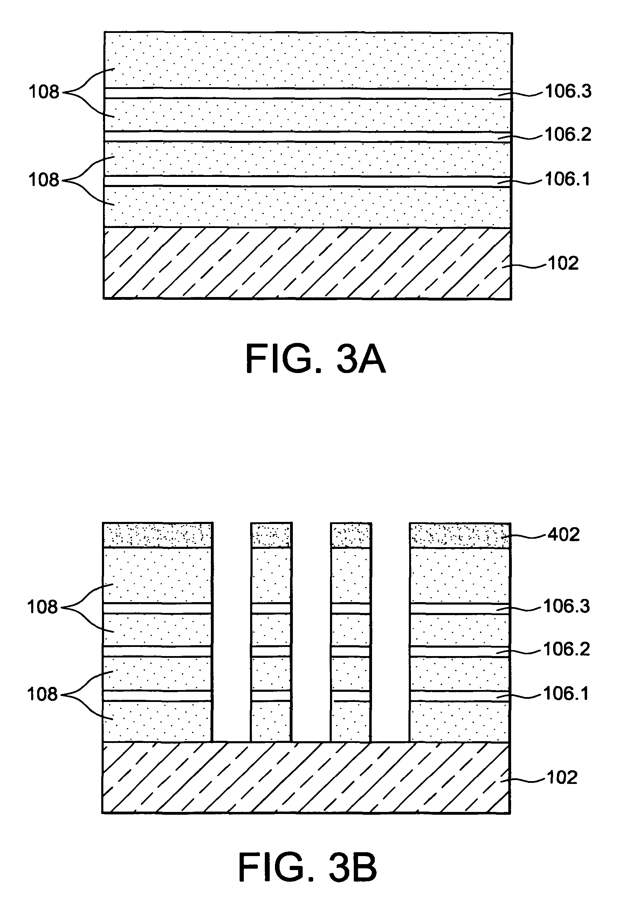

Un procédé de réalisation du dispositif de mémorisation va maintenant être décrit en liaison avec les figures 3A à 3E.

Comme représenté sur la figure 3A, on réalise tout d'abord, sur le substrat 102, un empilement formé des couches isolantes 108 et des couches mémoires 106.1 à 106.3. Ces couches isolantes 108 et ces couches mémoires 106.1 à 106.3 peuvent par exemple être réalisées par des dépôts successifs de même nature, tels que des dépôts PVD (dépôt physique en phase vapeur). Le substrat 102 peut également comporter, avant la réalisation de l'empilement, une couche technologique, comportant par exemple les moyens de mesure de courant 118 représentés sur la figure 1.

De plus, lorsque le dispositif de mémorisation comporte un empilement de couches 202 formant une structure « miroir », celui-ci peut être réalisé sur le substrat 102 préalablement au premier dépôt de la première couche isolante 108.

Il est possible de réaliser, entre une ou plusieurs étapes de dépôt d'une couche de l'empilement (isolante ou couche mémoire), une étape de planarisation mécano-chimique de la couche déposée.

Une couche de protection mécanique peut également être formée au-dessus de l'empilement précédemment réalisé, par exemple à base de diamant ou de plastique et d'une épaisseur comprise entre environ 3 nm et 10 nm lorsqu'elle est à base de diamant, et entre environ 10 µm et 200 µm lorsqu'elle est à base de plastique.

De préférence, la première couche et la dernière couche de l'empilement déposées sur le substrat 102 sont des couches isolantes 108.

On structure ensuite l'empilement en déposant un masque de lithographie 402 sur l'empilement, puis en réalisant une gravure, par exemple une gravure ionique IBE, ou une gravure ionique réactive (RIE) ou encore gravure plasma ICP (« Induced Coupled Plasma » en anglais), offrant une sélectivité de gravure importante, de l'empilement des couches isolantes 108 et des couches mémoires 106.1 à 106.3 (figure 3B). Cette étape de structuration permet de réaliser des trous, futurs emplacements des colonnes 110 du dispositif de mémorisation. Le masque 402 peut par exemple être une couche de résine photosensible, insolée au travers d'un masque ou une couche à base d'un matériau plastique et déformée par un procédé de moulage. Le masque 402 permet de transférer le motif définissant l'emplacement des colonnes dans l'empilement ainsi que la répartition des caissons dans l'empilement par un procédé de gravure, tel qu'une gravure ionique ou une gravure par ions réactifs. Le masque servant à l'insolation de la couche de résine ou le moule peut être avantageusement réalisé par un dépôt de nanoparticules ou d'un mélange de constituants non-miscibles. Cette étape de gravure permet également de réaliser le partitionnement en caissons 116 du dispositif de mémorisation de données.

On dépose alors de manière conforme, par exemple par un dépôt CVD avec précurseurs gazeux ou liquides, un matériau photoconducteur, par exemple à base de silicium amorphe ou d'oxyde de zinc, dans les trous précédemment gravés, afin de former les colonnes photoconductrices 110. Le matériau photoconducteur peut également être organique et dans ce cas, être déposé par dépôt à la tournette ou trempage. Des colonnes photoconductrices 110 similaires à celles représentées sur la figure 1 sont ainsi réalisées.

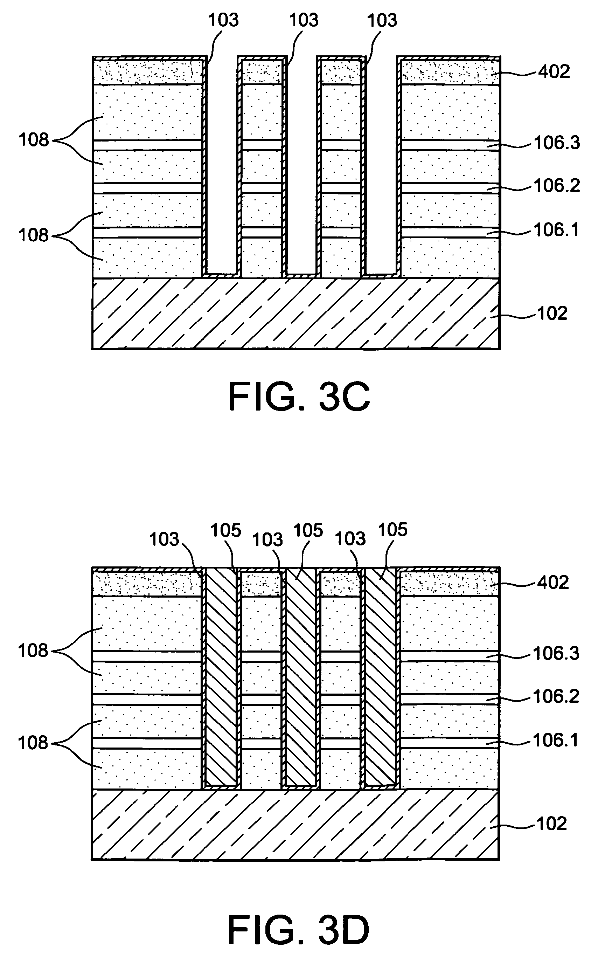

Toutefois, sur l'exemple des figures 3C à 3E, on réalise des colonnes 110 similaires à celles représentées sur la figure 2, c'est-à-dire comportant une première couche 103 conforme aux parois des trous et une partie centrale 105. Comme représenté sur la figure 3C, on réalise donc un premier dépôt conforme dans les trous, par exemple un dépôt CVD avec précurseurs gazeux ou liquides, une couche 103 de semi-conducteur de type N ou P. Un composé métallique 105, ou un autre semi-conducteur respectivement de type P ou N, est ensuite déposé dans les trous précédemment réalisés, sur la couche 103, afin de former les colonnes 110 (voir figure 3D). Les couches 103 et 105 peuvent également être obtenues par des croissances successives de couches dopées N et P. Une telle structure de photodiodes peut également être obtenue en alternant les gaz interagissant lors d'une croissance CVD ou VLS (Vapeur-Liquide-Solide) en plus du silane utilisé, comme par exemple de l'arsine et de la phosphine, permettant de réaliser des dopages respectivement P et N.

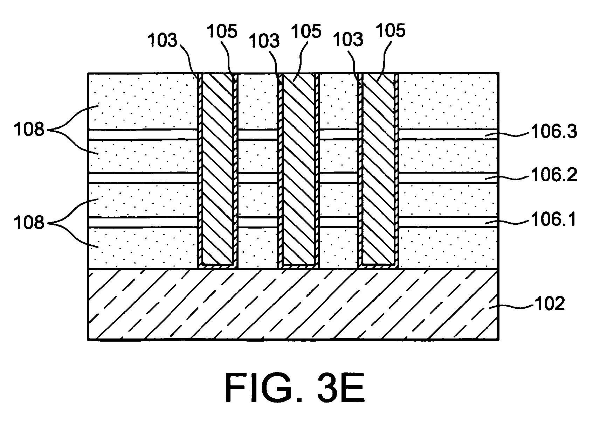

Comme représenté sur la figure 3E, on réalise ensuite, par exemple par un polissage mécano-chimique du dispositif, le retrait du masque 402 ainsi que des matériaux des colonnes 110 se trouvant sur le masque 402. Le retrait de ces matériaux peut également être réalisé par une gravure anisotrope, par exemple de type RIE.

La couche électriquement conductrice 120 peut ensuite être déposée sur l'empilement de couches et sur le sommet des colonnes 110, à moins que celle-ci ne soit déjà présente entre l'empilement de couches 106, 108 et le substrat 102.

On termine ensuite le dispositif de mémorisation de données en déposant une couche de protection, par exemple similaire à la couche 206 représentée sur la figure 2, par exemple à base de carbone diamant ou de plastique.

La structure réalisée est ensuite couplée à un réseau de sources lumineuses 112 tel que représenté sur les figures 1 et 2.

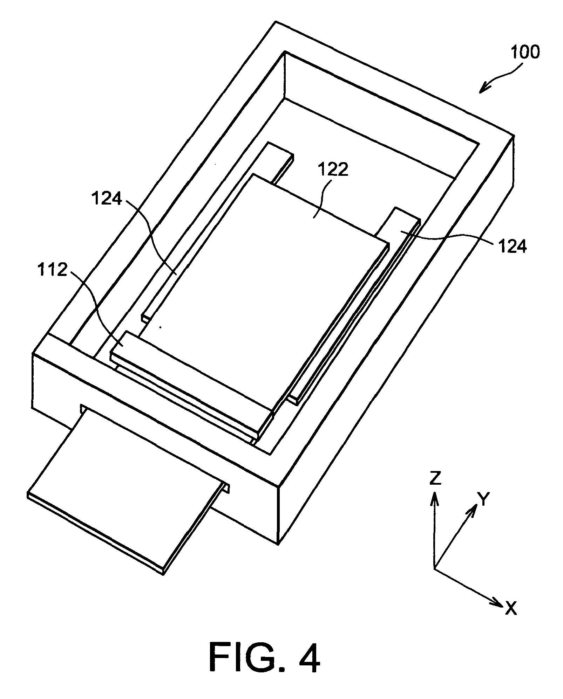

La figure 4 représente une vue schématique globale du dispositif de mémorisation 100. Celui-ci comporte le réseau de sources optiques 112 intégré en un système de type MOEMS apte à couvrir toute la largeur (dimension selon l'axe x) du support de stockage 122 qui est ici de forme rectangulaire. Ce système MOEMS est apte à translater les sources lumineuses sur une course égale ou supérieure au pas entre les sources lumineuses, typiquement égale à environ 100 µm selon l'axe x représenté sur la figure 4, par rapport au support de stockage 122. Le dispositif 100 comporte également des moteurs 124 permettant de déplacer le support de stockage 122 également selon l'axe y, mais sur une course de plusieurs centimètres, par exemple comprise entre environ 1 cm et 10 cm. Ainsi, toute la surface du support de stockage 122 peut être exposée sous le réseau de sources lumineuses. Ces moteurs 124 sont par exemple de type « stick slip » ou « piezo walk » ou « micro walker », c'est-à-dire des moteurs à inertie à nano-pas, permettant ainsi d'obtenir un déplacement précis du support de stockage 122. De plus, le dispositif 100 comporte deux moteurs 124 déplaçant chacun un côté du support de stockage 122. Ainsi, ces deux moteurs 124 peuvent ajuster la perpendicularité du mouvement du support de stockage 122 avec la direction de déplacement des sources lumineuses 112 (selon l'axe y).

De manière générale, le dispositif de mémorisation 100 ou 200 peut également être utilisé sous forme de media fixe, c'est-à-dire sans moyens de déplacement du support de stockage par rapport au réseau de sources lumineuses, par exemple sous forme de disque.

## Revendications

1. Dispositif (100, 200) de mémorisation de données, comportant :
- un empilement de couches comprenant au moins une couche mémoire (106) apte à réaliser un stockage de données dans une pluralité de portions de la couche mémoire (106) par une modification d'au moins une propriété physico-chimique du matériau desdites portions de la couche mémoire (106) sous l'effet d'un courant électrique traversant lesdites portions de la couche mémoire (106) ; **caractérisé en ce qu'**il comporte en outre :
- une pluralité de colonnes photoconductrices (110) disposées dans l'empilement de couches et traversant chaque couche de cet empilement,
chacune desdites portions de la couche mémoire (106) entourant une des colonnes photoconductrices (110).

2. Dispositif (100, 200) de mémorisation de données selon la revendication 1, dans lequel lesdites portions de la couche mémoire (106) sont de forme annulaire.

3. Dispositif (100, 200) de mémorisation de données selon l'une des revendications précédentes, dans lequel ladite couche mémoire (106) est à base d'au moins un matériau à changement de phase, et/ou les colonnes photoconductrices (110) sont à base d'au moins un matériau photoconducteur tel que du silicium non dopé et/ou de l'oxyde de zinc et/ou de l'antimoniure d'indium et/ou un alliage de tellure antimoine germanium Geₓb_{y}Te_{z} et/ou un matériau photoconducteur organique, et/ou les colonnes comportent au moins deux couches de semi-conducteur de conductivités complémentaires, ou une couche de semi-conducteur dopé et une couche métallique.

4. Dispositif (100, 200) de mémorisation de données selon l'une des revendications précédentes, dans lequel l'empilement de couches est formé par une alternance de couches isolantes (108) et de couches mémoires (106.1-106.3).

5. Dispositif (100) de mémorisation de données selon l'une des revendications précédentes, comportant en outre une pluralité de tranchées réalisées dans l'empilement de couches et traversant toutes les couches de l'empilement, formant plusieurs portions (116), isolées électriquement les unes des autres, de l'empilement de couches et des colonnes photoconductrices (110).

6. Dispositif (100, 200) de mémorisation de données selon l'une des revendications précédentes, comportant en outre au moins une couche électriquement conductrice (120) disposée contre l'empilement de couches et contre le sommet ou la base des colonnes photoconductrices (110).

7. Dispositif (100, 200) de mémorisation de données selon l'une des revendications précédentes, comportant en outre des moyens d'application de tension aux bornes de la couche mémoire (106), et/ou des moyens de sélection d'une ou plusieurs colonnes photoconductrices (110) et/ou des moyens (115) de sélection d'une ou plusieurs couches mémoires (106), et/ou des moyens (118) de mesure de courant circulant dans une ou plusieurs couches mémoires (106),

8. Dispositif (200) de mémorisation du données selon l'une des revendications précédentes, comportant en outre au moins une couche optiquement réfléchissante (202) et/ou au moins une couche de protection (206) formées contre l'empilement de couches.

9. Dispositif (100, 200) de mémorisation de données selon l'une des revendications précédentes, comportant en outre une pluralité de sources lumineuses (112) aptes à éclairer ladite pluralité de colonnes photoconductrices (110).

10. Dispositif (100, 200) de mémorisation de donnéés selon la revendication 9, dans lequel la pluralité de sources lumineuses (112) comporte un réseau de sources optiques de type VCSEL.

11. Dispositif (100, 200) de mémorisation de données selon l'une des revendications 9 ou 10, dans lequel au moins l'empilement de couches et les colonnes photoconductrices (110) forment un support de stockage (122) mobile par rapport à la pluralité de sources lumineuses (112), et comportant des moyens (124) de déplacement relatif du support de stockage (122) par rapport à la pluralité de sources lumineuses (112).

12. Dispositif (100, 200) de mémorisation de données selon la revendication 11, dans lequel la pluralité de sources lumineuses (112) sont disposées dans un système de type MOEMS apte à translater les sources lumineuses (112) par rapport au support de stockage (122), et/ou les moyens (124) de déplacement relatif du support de stockage (122) par rapport à la pluralité de sources lumineuses (112) comportant au moins un moteur de type MES.

13. Procédé de réalisation st' un Dispositif (100, 200) de mémorisation de données, comportant ₄14 moins les étapes de :
- réalisation d'un empilement de couches comportant au moins une couche mémoire (106) apte à réaliser un stockage de données dans une pluralité da portions de la couche mémoire (106) par une modification d'au moins une propriété physico-chimique du matériau desdites portions de la couche mémoire (106) sous l'effet d'un courant électrique traversant lesdites portions de à couche mémoire (106); **caractérisé en ce qu'**il comporte les étapes de :
- gravure d'une pluralité de trous dans l'empilement de couches, les trous traversant chaque couche de l'empilement,
- réalisation de colonnes photoconductrices (110) dans les trous, chacune desdites portions de la couche mémoire (106) entourant une des colonnes photoconductrices (110).

14. Procédé de réalisation selon la revendication 13, comportant en outre une étape de réalisation d'une pluralité de sources lumineuses (112) aptes à éclairer la pluralité de colonnes photoconductrices (110).

15. Procédé de réalisation selon l'une des revendications 13 ou 14, dans lequel la réalisation de l'empilement de couches est obtenue par des étapes de dépôts alternés de couches isolantes (108) et de couches mémoires (106).

16. Procédé de réalisation selon l'une des revendications 13 à 15, dans lequel l'étape de réalisation des colonnes photoconductrices (110) comporte une étape de remplissage des trous par au moins un matériau photoconducteur, ou une première étape de dépôt conforme aux parois des trous d'une première couche (103) à base d'un semi-conducteur dopé d'un premier type de conductivité et une seconde étape de dépôt d'un semi-conducteur (105) dopé d'un second type de conductivité opposé au premier type de conductivité ou d'un matériau électriquement conducteur sur la première couche.

17. Procédé de réalisation selon l'une des revendications 13 à 16, comportant en outre, après l'étape de réalisation des colonnes photoconductrices (110), une étape de dépôt d'une couche électriquement conductrice (120) et/ou d'une couche de protection mécanique (206) sur l'empilement de couches et sur les colonnes photoconductrices (110).

18. Procédé de réalisation selon l'une des revendications 13 à 17, comportant en outre, avant l'étape de réalisation de l'empilement de couches, une étape de dépôt d'une couche électriquement conductrice (120) et/ou d'au moins une couche optiquement réflectrice (202) contre un substrat (102), l'empilement de couches étant réalisé sur la couche électriquement conductrice (120) et/ou sur la couche optiquement réflectrice (202).

## Claims

1. Data storage device (100, 200), comprising:
- a stack of layers comprising at least one memory layer (100) able to carry out a storage of data in a plurality of portions of the memory layer (106) by a modification of at least one physico-chemical property of the material of said portions of the memory layer (106) under the effect of an electric current passing through said portions of the memory layer (106); **characterized in that** it comprises:
- a plurality of photoconductive columns (110) disposed in the stack of layers and passing through each layer of this stack;
each of said portions of the memory layer (106) surrounding one of the photoconductive columns (110).

2. Data storage device (100, 200) according to claim 1, in which said portions of the memory layer (106) are annular in shape.

3. Data storage device (100, 200) according to one of the preceding claims, in which said memory layer (106) is based on at least one phase-change material, and/or the photoconductive columns (110) are based on at least one photoconductive material such as undoped silicon and/or zinc oxide and/or indium antimonide and/or an alloy of tellurium antimony germanium GeₓSb_{y}Te_{z} and/or an organic photoconductive material, and/or the columns comprise at least two layers of semiconductor with complementary conductivities, or a layer of doped semiconductor and a metal layer.

4. Data storage device (100, 200) according to one of the preceding claims, in which the stack of layers is formed by an alternation of insulating layers (108) and memory layers (106.1 - 106.3).

5. Data storage device (100) according to one of the preceding claims, also comprising a plurality of trenches produced in the stack of layers and passing through all the layers in the stack, forming several portions (116), electrically insulated from one another, of the stack of layers and photoconductive columns (110).

6. Data storage device (100, 200) according to one of the preceding claims, also comprising at least one electrically conductive layer (120) disposed against the stack of layers and against the top or base of the photoconductive columns (110).

7. Data storage device (100, 200) according to one of the preceding claims, also comprising means of applying voltage to the terminals of the memory layer (106), and/or means of selecting one or more photoconductive columns (110) and/or means (115) of selecting one or more memory layers (106), and/or means (118) of measuring current flowing in one or more memory layers (106).

8. Data storage device (200) according to one of the preceding claims, also comprising at least one optically reflective layer (202) and/or at least one protection layer (206) formed against the stack of layers.

9. Data storage device (100, 200) according to one of the preceding claims, also comprising a plurality of light sources (112) able to illuminate said plurality of photoconductive columns (110).

10. Data storage device (100, 200) according to claim 9, in which the plurality of light sources (112) comprises an array of optical sources of the VCSEL type.

11. Data storage device (100, 200) according to one of claims 9 or 10, in which at least the stack of layers and the photoconductive columns (110) form a storage medium (122) able to move with respect to the plurality of light sources (112), and comprising means (124) for relatively moving the storage medium (122) with respect to the plurality of light sources (112).

12. Data storage device (100, 200) according to claim 11, in which the plurality of light sources (112) are disposed in a system of the MOEMS type able to translate the light sources (112) with respect to the storage medium (122), and/or the means (124) for relatively moving the storage medium (122) with respect to the plurality of light sources (112) comprise at least one motor of the MEMS type.

13. Method of producing a data storage device (100, 200), comprising at least the steps of:
- producing a stack of layers comprising at least one memory layer (106) able to carry out a data storage in a plurality of portions of the memory layer (106) by a modification of at least one physico-chemical property of the material of said portions of the memory layer (106) under the effect of an electric current passing through said portions of the memory layer (106); **characterized in that** it comprises the steps of:
- etching a plurality of holes in the stack of layers, the holes passing through each layer of the stack;
- producing photoconductive columns (110) in the holes, each of said portions of the memory layer (106) surrounding one of the photoconductive columns (110).

14. Method according to claim 13, also comprising a step of producing a plurality of light sources (112) able to illuminate the plurality of photoconductive columns (110).

15. Method according to one of claims 13 or 14, in which the production of the stack of layers is obtained by steps of alternating depositions of insulating layers (108) and memory layers (106).

16. Method according to one of claims 13 to 15, in which the step of producing photoconductive columns (110) comprises a step of filling holes by at least one photoconductive material, or a first conformal deposition at the walls of the holes of a first layer (103) based on a doped semiconductor with a first conductivity type and a second step of deposition of a doped semiconductor (105) of a second conductivity type opposite to the first conductivity type or of an electrically conductive material on the first layer.

17. Method according to one of claims 13 to 16, also comprising, after the step of producing the photoconductive columns (110), a step of deposition of an electrically conductive layer (120) and/or a mechanical protection layer (206) on the stack of layers and on the photoconductive columns (110).

18. Method according to one of claims 13 to 17, also comprising, before the step of producing the stack of layers, a step of depositing an electrically conductive layer (120) and/or at least one optically reflective layer (202) against a substrate (102), the stack of layers being produced on the electrically conductive layer (120) and/or on the optically reflective layer (202).

## Patentansprüche

1. Datenspeichereinrichtung (100, 200), umfassend:
- einen Stapel von Schichten, welcher wenigstens eine Speicherschicht (106) umfasst, die dazu geeignet ist, eine Speicherung von Daten in einer Mehrzahl von Abschnitten der Speicherschicht (106) durchzuführen, durch eine Veränderung von wenigstens einer physikalisch-chemischen Eigenschaft des Materials der Abschnitte der Speicherschicht (106) unter der Einwirkung eines elektrischen Stromes, welcher durch die Abschnitte der Speicherschicht (106) hindurchfließt, **dadurch gekennzeichnet, dass** sie weiterhin umfasst:
- eine Mehrzahl von fotoleitfähigen Säulen (110), die in dem Stapel von Schichten vorgesehen sind und jede Schicht von diesem Stapel durchqueren,
wobei jeder von den Abschnitten der Speicherschicht (106) eine der fotoleitfähigen Säulen (110) umgibt.

2. Datenspeichereinrichtung (100, 200) nach Anspruch 1, wobei die Abschnitte der Speicherschicht (106) eine Ring-Form aufweisen.

3. Datenspeichereinrichtung (100, 200) nach einem der vorhergehenden Ansprüche, wobei die Speicherschicht (106) auf wenigstens einem Material mit Phasenübergang basiert, oder/und die fotoleitfähigen Säulen (110) auf wenigstens einem fotoleitfähigen Material wie undotiertem Silizium oder/und Zinkoxid oder/und Indiumantimonid oder/und einer Tellur-Antimon-Germanium Legierung GeₓSb_{y}Te_{z} oder/und einem organischen fotoleitfähigen Material basieren, oder/und die Säulen wenigstens zwei Schichten aus Halbleitern mit komplementären Leitfähigkeiten aufweisen, oder eine Schicht aus einem dotierten Halbleiter und eine metallische Schicht.

4. Datenspeichereinrichtung (100, 200) nach einem der vorhergehenden Ansprüche, wobei der Stapel von Schichten gebildet ist durch abwechselnd isolierende Schichten (108) und Speicherschichten (106.1-106.3).

5. Datenspeichereinrichtung (100) nach einem der vorhergehenden Ansprüche, weiter umfassend eine Mehrzahl von Gräben, die in dem Stapel von Schichten ausgeführt sind und alle Schichten des Stapels durchqueren, wodurch mehrere, elektrisch voreinander isolierte Abschnitte (116) von dem Stapel von Schichten und den fotoleitfähigen Säulen (110) gebildet sind.

6. Datenspeichereinrichtung (100, 200) nach einem der vorhergehenden Ansprüche, weiterhin umfassend wenigstens eine elektrisch leitfähige Schicht (120), die an dem Stapel von Schichten angeordnet ist und an der Spitze oder der Basis der fotoleitfähigen Säulen (110).

7. Datenspeichereinrichtung (100, 200) nach einem der vorhergehenden Ansprüche, weiterhin umfassend Mittel zum Anlegen von Spannung an die Abschlüsse der Speicherschicht (106) oder/und Mittel zum Auswählen von einer oder mehreren fotoleitfähigen Säulen (110) oder/und Mittel (115) zum Auswählen von einer oder mehreren Speicherschichten (106) oder/und Mittel (118) zum Messen von Strom, der in einer oder mehreren Speicherschichten (106) fließt.

8. Datenspeichereinrichtung (200) nach einem der vorhergehenden Ansprüche, weiterhin umfassend wenigstens eine optisch reflektierende Schicht (202) oder/und wenigstens eine Schutzschicht (206), die an dem Stapel von Schichten ausgebildet ist/sind.

9. Datenspeichereinrichtung (100, 200) nach einem der vorhergehenden Ansprüche, weiterhin umfassend eine Mehrzahl von Lichtquellen (112), die dazu geeignet sind, die Mehrzahl von fotoleüfähigen Säulen (110) zu beleuchten.

10. Datenspeichereinrichtung (100, 200) nach Anspruch 9, wobei die Mehrzahl von Lichtquellen (112) ein Netz von optischen Quellen vom Typ VCSEL umfasst.

11. Datenspeichereinrichtung (100, 200) nach einem der Ansprüche 9 oder 10, wobei wenigstens der Stapel von Schichten und die fotoleitfähigen Säulen (110) ein Speichermedium (122) bilden, das in Bezug auf die Mehrzahl von Lichtquellen (112) beweglich ist, und Mittel (124) für eine relative Verlagerung des Speichermediums (122) in Bezug auf die Mehrzahl von Lichtquellen (112) umfasst.

12. Datenspeichereinrichtung (100, 200) nach Anspruch 11, wobei die Mehrzahl von Lichtquellen (112) in einem System vom Typ MOEMS angeordnet sind, welches dazu geeignet ist, die Lichtquellen (112) in Bezug auf das Speichermedium (122) zu verschieben, oder/und die Mittel (124) zur relativen Verlagerung des Speichermediums (122) in Bezug auf die Mehrzahl von Lichtquellen (112) wenigstens einen Motor vom Typ MEMS umfassen.

13. Herstellungsverfahren für eine Datenspeichereinrichtung (100, 200), umfassend wenigstens die Schritte:
- Herstellung von einem Stapel von Schichten, umfassend wenigstens einen Speicherschicht (106), die dazu geeignet ist, eine Speicherung von Daten in einer Mehrzahl von Abschnitten der Speicherschicht (106) durchzuführen, durch eine Veränderung von wenigstens einer physikalisch-chemischen Eigenschaft des Materials der Abschnitte von der Speicherschicht (106), unter der Einwirkung von einem elektrischen Strom, welcher durch die Abschnitte von der Speicherschicht (106) hindurchfließt, **dadurch gekennzeichnet, dass** es die Schritte umfaßt:
- Ätzen von einer Mehrzahl von Löchern in den Stapel von Schichten, wobei die Löcher jede Schicht des Stapels durchqueren,
- Herstellung von fotoleitfähigen Säulen (110) in den Löchern, wobei jeder der Abschnitte der Speicherschicht (106) eine der fotoleitfähigen Säulen (110) umgibt.

14. Herstellungsverfahren nach Anspruch 13, weiterhin umfassend einen Schritt des Herstellens von einer Mehrzahl von Lichtquellen (112), die geeignet sind, die Mehrzahl von fotoleitfähigen Säulen (110) zu beleuchten.

15. Herstellungsverfahren nach einem der Ansprüche 13 oder 14, wobei die Herstellung des Stapels von Schichten durch Schritte des abwechselnden Aufbringens von isolierenden Schichten (108) und Speicherschichten (106) erhalten wird.

16. Herstellungsverfahren nach einem der Ansprüche 13 bis 15, wobei der Schritt der Herstellung der fotoleitfähigen Säulen (110) einen Schritt umfasst, die Löcher mit wenigstens einem fotoleitfähigen Material zu füllen, oder einen ersten Schritt, konform zu den Wänden der Löcher eine erste Schicht (103) auf Basis von einem dotierten Halbleiter mit einem ersten Leitfähigkeitstyp aufzubringen, und einen zweiten Schritt, einen dotierten Halbleiter (105) mit einem zweiten, zum ersten Leitfähigkeitstyp entgegengesetzten Leitfähigkeitstyp oder ein elektrisch leitfähiges Material auf die erste Schicht aufzubringen.

17. Herstellungsverfahren nach einem der Ansprüche 13 bis 16, umfassend weiterhin, nach dem Schritt der Herstellung der fotoleitfähigen Säulen (110), einen Schritt des Aufbringens einer elektrisch leitfähigen Schicht (120) oder/und einer mechanischen Schutzschicht (206) auf den Stapel von Schichten und auf die fotoleitfähigen Säulen (110).

18. Herstellungsverfahren nach einem der Ansprüche 13 bis 17, weiterhin umfassend, vor dem Schritt der Herstellung des Stapel von Schichten, einen Schritt des Aufbringens einer elektrisch leitfähigen Schicht (120) oder/und wenigstens einer optisch reflektierenden Schicht (202) auf ein Substrat (102), wobei der Stapel von Schichten auf der elektrisch leitfähigen Schicht (120) oder/und auf der optisch reflektierenden Schicht (202) hergestellt wird.
